# EUROPÄISCHE PATENTSCHRIFT

(11) **EP 2 194 769 B1**
(45) Veröffentlichungstag und Bekanntmachung des Hinweises auf die Patenterteilung: **25.01.2012**
(21) Anmeldenummer: 09012247.4
(22) Anmeldetag: 26.09.2009
(51) Int. Cl.: H05K 7/14, H01L 25/07, H01R 13/24

(54) **Leistungshalbleitermodul mit vorgespannter Hilfskontaktfeder**
Semiconductor module with pre-tensioned auxiliary contact spring
Module semi-conducteur de puissance doté d'un ressort de contact auxiliaire prétendu

(30) Priorität: 19.11.2008 DE 102008057832
(43) Veröffentlichungstag der Anmeldung: 09.06.2010
(73) Patentinhaber: SEMIKRON Elektronik GmbH & Co. KG, 90431 Nürnberg (DE)
(72) Erfinder: Lederer, Marco, 90453 Nürnberg (DE)

(56) Entgegenhaltungen:
- EP-A2- 1 933 380
- DE-A1-102006 006 421
- DE-A1-102006 058 692

## Beschreibung

Die Erfindung beschreibt ein Leistungshalbleitermodul in Druckkontaktausführung mit mindestens einem als Kontaktfeder ausgebildeten Anschlusselement. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind druckkontaktierte Leistungshalbleitermodule, wie sie aus der DE 42 37 632 A1 bekannt sind. In dieser Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgeht.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Aus der DE 10 2004 025 609 A1 ist ein Leistungshalbleitermodul mit einer Grundplatte und als Kontaktfedern ausgebildeten Hilfsanschlusselementen bekannt. Gemäß dieser Druckschrift werden die Kontaktfedern zur sicheren elektrischen Kontaktierung mittels eines Deckels mit Druck beaufschlagt. Hierbei sind die Kontaktfedern in einer nicht detailliert offen gelegten Halterung des Gehäuses angeordnet.

Aus der DE 10 2006 006 421 A1 ist ein Leistungshalbleitermodul mit mindestens einem Anschlusselement, das als eine Kontaktfeder mit einer ersten Kontakteinrichtung, einem federnden Abschnitt und einer zweiten Kontakteinrichtung ausgebildet ist, bekannt. Hierbei weist ein erster Kunststoffformkörper einen senkrecht zum Substrat angeordneten Schacht zur Aufnahme eines Anschlusselements auf. Dieser Schacht weist seinerseits eine seitliche Ausnehmung zur verdrehsicheren Anordnung des Anschlusselements und eine Aussparung für einen zugeordneten Teilkörper eines zweiten Kunststoffformkörper auf, wobei dieser Teilkörper ebenfalls eine seitliche Ausnehmung und auf der dem Substrat abgewandten Seite eine Ausnehmung für die erste Kontakteinrichtung des Anschlusselements aufweist und diese hier hindurch reicht.

Ebenfalls ist aus der DE 10 2006 058 692 A1 ein Leistungshalbleitermodul mit Kontaktfedern bekannt. Gemäß der Schrift haben die Kontaktfedern eine S-förmige Verformung im Bereich der unteren Kontakteinrichtung. Diese Verformung dient gemäß der Schrift zum Schutz vor Herausfallen der Kontaktfeder. Die Verformung der Kontaktfeder ist zwischen dem Substrat und den Ausnehmungen des Gehäuses positioniert.

Aus der DE 10 2005 024 900 A1 ist ebenfalls eine gegen Herausfallen gesicherte Kontaktfeder bekannt. Die Kontaktfeder wird gemäß der Druckschrift durch die unteren Windungen der Feder, welche einen größeren Durchmesser als die oberen Windungen der Feder besitzen, im Gehäuse gehalten und gewährleistet so einen Schutz vor Herausfallen der Feder aus dem Gehäuse.

Nachteilig am Stand der Technik ist hier ein technisch bedingter zu großer Überstand der Hilfskontaktfeder über das Gehäuse im unmontiertem Zustand und ohne angeordnete Steuerplatine. Die Druckkontaktfeder steht maximal ihren gesamten Federweg über das Gehäuse hinaus, was die Gefahr der Beschädigung in Form einer Deformation des Federkopfes, also der oberen Kontakteinrichtung des Hilfsanschlusses, erhöht. Die Federtrefferfläche bzw. die Kontaktfläche auf der montierbaren Steuerplatine muss groß genug gestaltet werden, um unter allen Umständen eine sichere elektrische Kontaktierung des Leistungshalbleitermoduls mit der montierbaren Steuerplatine zu gewährleisten.

Der vorliegenden Erfindung liegt die Aufgabe zu Grunde ein Leistungshalbleitermodul mit Druckfederkontakten anzugeben, wobei der Überstand der oberen Kontakteinrichtung reduziert ist und damit auch das Risiko einer Deformation.

Diese Aufgabe wird erfindungsgemäß gelöst, durch ein Leistungshalbleitermodul mit den Merkmalen des Anspruchs 1. Bevorzugte Ausführungsformen sind in den abhängigen Ansprüchen beschrieben.

Der erfinderische Gedanke geht von einem Leistungshalbleitermodul mit mindestens einem Anschlusselement in der Form einer Kontaktfeder aus.

Das Leistungshalbleitermodul weist weiterhin ein Gehäuse, ein Druckstück, ein Substrat mit mindestens einer Kontaktfläche auf.

Die Kontaktfeder weist eine erste Kontakteinrichtung, einen federnden Abschnitt und eine zweite Kontakteinrichtung auf. Die erste Kontakteinrichtung ist vorzugsweise stiftartig oder kreisbogenförmig ausgebildet und elektrisch leitend mit einer Kontaktfläche des Substrates verbunden.

Die zweite Kontakteinrichtung der Kontaktfeder weist eine halbkreisähnliche Form auf, an deren Anfang und Ende je eine Verformung angeordnet ist. Die Verformungen am Anfang und am Ende der zweiten Kontakteinrichtung sind vorzugsweise V-förmig ausgebildet. Das Druckstück weist mindestens zwei Anschlagelemente je Anschlusselement zu dessen Anordnung auf. Die Anschlagelemente des Druckstückes beaufschlagen die Verformungen der zweiten Kontakteinrichtung der Kontaktfeder mit Druck wodurch die Kontaktfeder über den federnden Abschnitt vorgespannt wird. Mittels der Vorspannung der Kontaktfeder besteht nach Anordnung des Druckstückes eine sichere und konstante elektrische Kontaktierung der ersten Kontakteinrichtung mit der zugeordneten Kontaktfläche des Substrates des Leistungshalbleitermoduls.

Mittels der Vorspannung der Kontaktfeder wird der Überstand über das Druckstück und somit das Risiko der Deformation verringert. Zudem wird die kontaktsichere Anordnung einer Steuerplatine ermöglicht.

Die erfinderische Lösung wird an Hand der Ausführungsbeispiele der Fig. 1 bis 4 weiter erläutert.

Fig. 1 zeigt einen Schnitt durch ein erfindungsgemäßes Leistungshalbleitermodul vor der Positionierung des Druckstücks.

Fig. 2 zeigt einen Schnitt durch das Leistungshalbleitermodul gemäß der Fig. 1 mit positioniertem Druckstück.

Fig. 3 zeigt den Schnitt durch das Leistungshalbleitermodul gemäß Fig. 1 mit angeordneter Steuerplatine.

Fig. 4 zeigt den Aufbau einer Kontaktfeder.

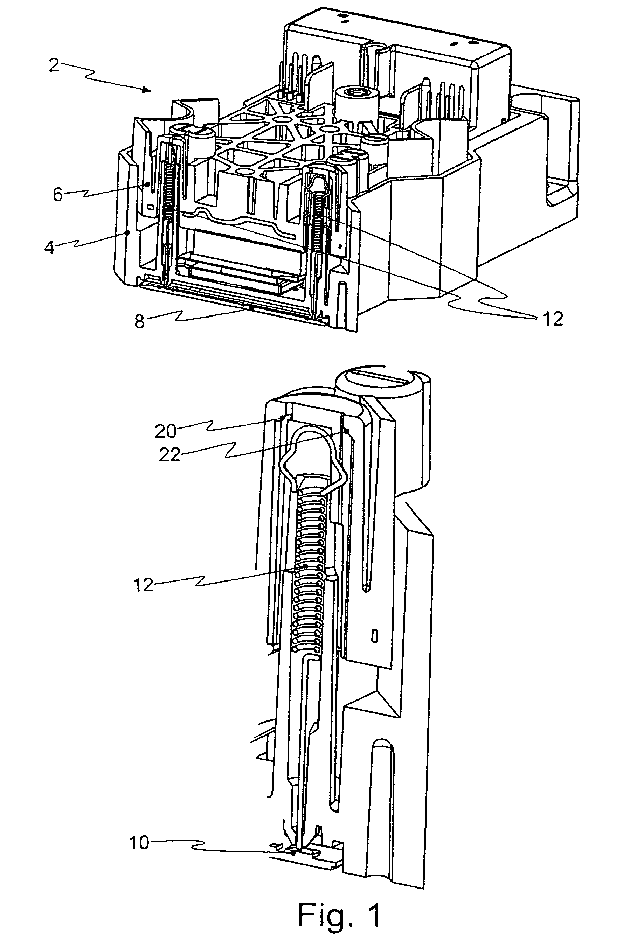

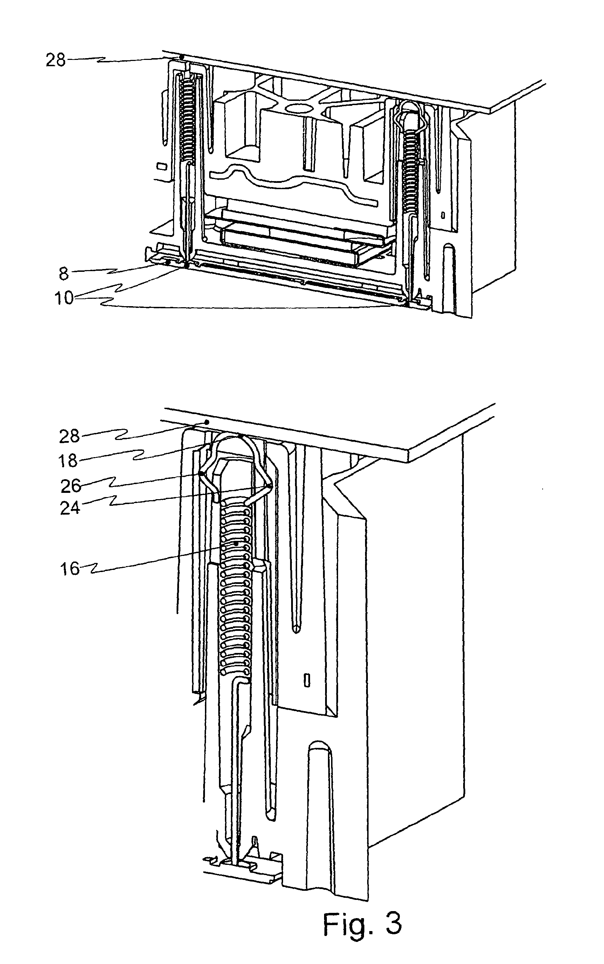

Fig. 1 zeigt einen Schnitt durch ein erfindungsgemäßes Leistungshalbleitermodul (2) vor der Positionierung des Druckstücks (6). Hierbei sind die Kontaktfedern (12) beweglich in den Schächten angeordnet. Das Druckstück (6) ist hier mit den Anschlagelementen (20; 22) dargestellt. Ebenfalls weist das Leistungshalbleitermodul (2) ein Substrat (8) auf, welches Kontaktflächen (10) aufweist. Die Kontaktflächen (10) auf dem Substrat (8) dienen zur elektrischen Kontaktierung des Substrates (8) über die Kontaktfedern (12) mit auf dem Leistungshalbleitermodul (2) montierbaren Steuerplatinen (Fig. 3: 28).

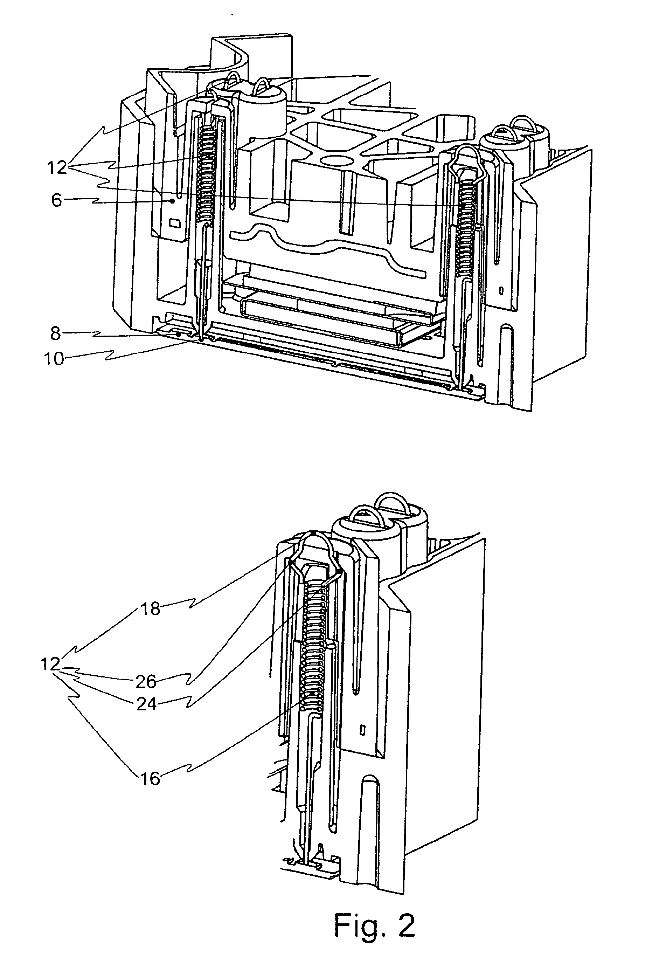

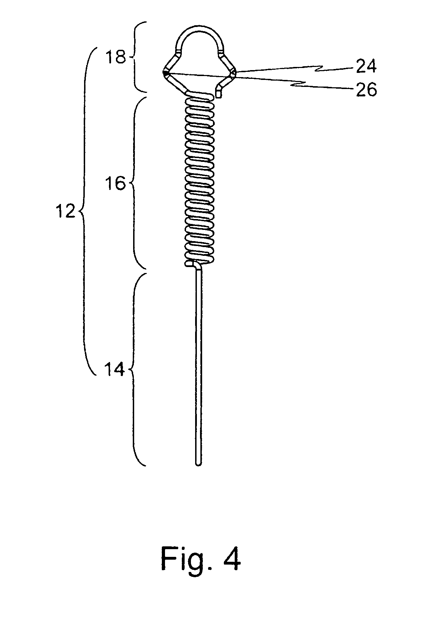

Fig. 2 zeigt einen Schnitt durch das Leistungshalbleitermodul (2) gemäß der Fig. 1 mit positioniertem Druckstück (6). Durch das Einsetzen des Druckstückes (6) werden die V-förmigen Verformungen (24; 26) der zweiten Kontakteinrichtung (18) der Kontaktfeder (12) über die Anschlagelemente (20; 22) des Druckstückes (6) mit Druck beaufschlagt und erzeugen dadurch eine Vorspannung der Kontaktfeder (12). Durch die Vorspannung der Kontaktfeder (12) wird die erste Kontakteinrichtung (Fig. 4: 14) der Kontaktfeder (12) sicher und konstant elektrisch leitend mit den Kontaktflächen (10) des Substrates (8) verbunden. Ebenfalls wird durch die Vorspannung der Kontaktfeder (12) der Überstand der zweiten Kontakteinrichtung (18) über das Druckstück (6) reduziert und damit das Risiko einer Deformation der zweiten Kontakteinrichtung (18) der Kontaktfeder (12) verringert.

Fig. 3 zeigt den Schnitt durch das Leistungshalbleitermodul (2) gemäß Fig. 1 mit angeordneter Steuerplatine (28). Die zweite Kontakteinrichtung (18) der Kontaktfeder (12) wird hier mit Druck durch die Steuerplatine (28) beaufschlagt und um den Überstand der zweiten Kontakteinrichtung (18) über das Druckstück (6) durchgedrückt. Es besteht hier über die Kontaktfeder (12) eine sichere elektrische Kontaktierung zwischen den Kontaktflächen der Steuerplatine (28) und den Kontaktflächen (10) auf dem Substrat (8). Die V-förmigen Verformungen (24, 26) der zweiten Kontakteinrichtung (18) werden hierbei nicht mehr durch die Anschlagelemente (20, 22) des positioniertem Druckstückes (6) mit Druck beaufschlagt, wodurch die sichere elektrische Kontaktierung der Kontaktflächen der Steuerplatine (28) und der zweiten Kontakteinrichtung (18) der Kontaktfeder (12) nicht mehr durch die Vorspannung mit den durch die Anschlagelemente (20, 24) mit Druck beaufschlagten Verformungen (24, 26) garantiert wird.

Fig. 4 zeigt den Aufbau einer Kontaktfeder (12) bestehend aus einer ersten Kontakteinrichtung (14), einem federnden Abschnitt (16) und einer zweiten Kontakteinrichtung (18). Die erste Kontakteinrichtung (14) ist stiftartig, oder hier nicht dargestellt kreisbogenförmig, ausgebildet. Die zweite Kontakteinrichtung (18) weist einen halbkreisförmigen Abschnitt zur Kontaktierung mit der Steuerplatine (28) auf. Am Ende und am Anfang des halbkreisförmigen Abschnitts sind jeweils eine V-förmige Verformung (24; 26) angeordnet, wobei eine der V-förmigen Verformungen (24, 26) mit dem federnden Abschnitt (16) verbunden ist. Die Scheitelpunkte der beiden V-förmigen Verformungen (24; 26) reichen von der Längsachse der Kontaktfeder (12) weg und stehen sich einander gegenüber.

## Patentansprüche

1. Leistungshalbleitermodul (2) mit einem Gehäuse (4), einem Druckstück (6), einem Substrat (8) mit mindestens einer Kontaktfläche (10) und mindestens einem nach außen führenden Anschlusselement (12),
wobei das Anschlusselement als Kontaktfeder (12) mit einer ersten Kontakteinrichtung (14), einem federnden Abschnitt (16) und einer zweiten Kontakteinrichtung (18) ausgebildet ist,
wobei das Druckstück (6) mindestens zwei Anschlagelemente (20; 22) je Anschlusselement (12) aufweist,
wobei die erste Kontakteinrichtung (14) der Kontaktfeder (12) elektrisch leitend mit den Kontaktflächen (10) des Substrates (8) verbunden ist,
wobei die zweite Kontakteinrichtung (18) der Kontaktfeder (12) halbkreisförmig ausgebildet ist **dadurch gekennzeichnet, dass** am Beginn und am Ende der Halbkreisform der zweiten Kontakteinrichtung (18) der Kontaktfeder (12) jeweils mindestens eine Verformung (24; 26) ausgebildet ist,
wobei durch die Verformungen (24; 26) der zweiten Kontakteinrichtung (18), mittels der beiden Anschlagelemente (20; 22) des Druckstückes (6), die Kontaktfeder (12) mit Druck beaufschlagt ist und **dadurch** die Kontaktfeder (12) eine Vorspannung aufweist.

2. Leistungshalbleitermodul (2) nach Anspruch 1,
wobei die Verformungen (24; 26) der zweiten Kontakteinrichtung (18) der Kontaktfeder (12) V-förmig ausgebildet sind und der Scheitelpunkt der jeweiligen V-förmigen Verformungen (24; 26) von der Längsachse der Feder wegreichen und die beiden Verformungen (24; 26) sich einander gegenüber stehen und mindestens eine der beiden V-förmigen Verformungen (24, 26) mit dem federnden Abschnitt (16) der Kontaktfeder (12) verbunden ist.

3. Leistungshalbleitermodul (2) nach Anspruch 1,
wobei die erste Kontakteinrichtung (14) stiftartig oder kreisbogenförmig ausgebildet ist.

4. Leistungshalbleitermodul (2) nach den Ansprüchen 1 oder 2,
wobei mittels der Vorspannung der Kontaktfeder (12) diese eine positionsgenauere elektrische Kontaktierung mit den Kontaktflächen auf einer, auf dem Leistungshalbleitermodul (2), montierbaren Steuerplatine (28) aufweist.

5. Leistungshalbleitermodul (2) nach den Ansprüchen 1 oder 3,
wobei mittels der Vorspannung der Kontaktfeder (12) diese eine sichere und konstante elektrische Kontaktierung der Kontaktfeder (12) mit den Kontaktflächen (10) auf dem Substrat (8) des Leistungshalbleitermoduls (2) aufweist.

## Claims

1. A power semiconductor module (2) with a housing (4), a pressure member (6), a substrate (8) with at least one contact surface (10), and at least one connecting element (12) leading outwards, wherein
the connecting element is designed as a contact spring (12), with a first contact device (14), an elastic section (16), and a second contact device (18), wherein
the pressure member (6) has at least two stop elements (20, 22) per connecting element (12), wherein
the first contact device (14) of the contact spring (12) is connected with the contact surfaces (10) of the substrate (8) in an electrically conducting manner, wherein
the second contact device (18) of the contact spring (12) is designed in the shape of a semicircle,
**characterised in that** at the start and at the end of the semicircular shape of the second contact device (18) of the contact spring (12) at least one deformation (24, 26) is arranged in each case, wherein
by means of the deformations (24, 26) of the second contact device (18), pressure is applied to the contact spring (12) by means of the two stop elements (20, 22) of the pressure member (6), and as a result the contact spring (12) has a preloading.

2. The power semiconductor module (2) according to Claim 1,
wherein
the deformations (24, 26) of the second contact device (18) of the contact spring (12) are designed in a V-shape, and the apex points of the respective V-shaped deformations extend away from the longitudinal axis of the spring and the two deformations (24, 26) are located opposite one another, and at least one of the two V-shaped deformations (24, 26) is connected with the elastic section (16) of the contact spring (12).

3. The power semiconductor module (2) according to Claim 1,
wherein
the first contact device (14) is designed in the form of a pin, or in the shape of a circular arc.

4. The power semiconductor module (2) in accordance with Claim 1 or 2, wherein
by means of the preloading of the contact spring (14) the latter has a more accurately positioned electrical contact with the contact surfaces on the control circuit board (28) that is mountable on the power semiconductor module (2).

5. The power semiconductor module (2) in accordance with Claim 1 or 3, wherein
by means of the preloading of the contact spring (12) the latter has a more reliable and constant electrical contact between the contact spring (12) and the contact surfaces (10) on the substrate (8) of the power semiconductor module (2).

## Revendications

1. Module à semi-conducteurs de puissance (2) comprenant un boîtier (4), une pièce de pression (6), un substrat (8) avec au moins une surface de contact (10) et au moins un élément de raccordement (12) allant vers l'extérieur,
l'élément de raccordement étant conçu sous forme de ressort de contact (12) avec un premier système de contact (14), une partie (16) élastique et un second dispositif de contact (18),
la pièce de pression (6) présentant au moins deux éléments de butée (20 ; 22) par élément de raccordement (12),
le premier dispositif de contact (14) du ressort de contact (12) étant relié de façon électro-conductrice aux surfaces de contact (10) du substrat (8),
le second dispositif de contact (18) du ressort de contact (12) étant conçu en forme de demi-cercle, **caractérisé en ce que**, à chaque fois, au moins une déformation (24 ; 26) se produit au début et à la fin de la forme de demi-cercle du second dispositif de contact (18) du ressort de contact (12),
le ressort de contact (12) étant sollicité en pression par les déformations (24 ; 26) du second dispositif de contact (18), au moyen des deux éléments de butée (20 ; 22) à la pièce de pression (6), et le contact de ressort (12) présentant ainsi une pré-tension.

2. Module à semi-conducteurs de puissance (2) selon la revendication 1,
les déformations (24 ; 26) du second dispositif de contact (18) du ressort de contact (12) étant conçues en forme de V et le sommet des déformations (24 ; 26) respectives en V partant de l'axe longitudinal du ressort et les deux déformations (24 ; 26) se faisant face et au moins l'une des deux déformations (24 ; 26) en V étant reliée à la partie (16) élastique du ressort de contact (12).

3. Module à semi-conducteurs de puissance (2) selon la revendication 1,
le premier dispositif de contact (14) étant conçu en forme de broche ou en forme d'arc de cercle.

4. Module à semi-conducteurs de puissance (2) selon les revendications 1 ou 2,
le ressort de contact (12) présentant au moyen de sa pré-tension un contact électrique plus précis au niveau de la position avec les surfaces de contact sur une platine de commande (28) pouvant être montée sur le module à semi-conducteurs de puissance (2).

5. Module à semi-conducteurs de puissance (2) selon les revendications 1 ou 3,
le ressort de contact (12) présentant au moyen de sa pré-tension un contact électrique sûr et constant du ressort de contact (12) avec les surfaces de contact (10) sur le substrat (8) du module à semi-conducteurs de puissance (2).
